# EUROPEAN PATENT APPLICATION

(11) **EP 4 749 816 A1**
(43) Date of publication of application: **27.05.2026**
(21) Application number: 24854281.3
(22) Date of filing: 14.06.2024
(51) Int. Cl.: H01Q 1/24, H04M 1/02, H05K 9/00

(54) **ELECTRONIC DEVICE COMPRISING CONDUCTIVE STRUCTURE**

(30) Priority: 16.08.2023 KR 20230107039; 15.11.2023 KR 20230158500
(71) Applicant: Samsung Electronics Co., Ltd., Suwon-si, Gyeonggi-do 16677 (KR)
(72) Inventor: KIM, Eungwon, Suwon-si Gyeonggi-do 16677 (KR); KIM, Byungjoon, Suwon-si Gyeonggi-do 16677 (KR); KIM, Yongyoun, Suwon-si Gyeonggi-do 16677 (KR); OH, Chanhee, Suwon-si Gyeonggi-do 16677 (KR)
(74) Representative: Gulde & Partner
(86) International application number: PCT/KR2024/008177
(87) International publication number: WO 2025/037728

(57) **Abstract**

An electronic device according to an embodiment may include: a housing including a front plate, a rear plate, and a lateral member surrounding at least part of an inner space between the front plate and the rear plate; a first electronic component disposed in the housing; a second electronic component spaced apart from the first electronic component and disposed in the housing; a circuit board disposed between the front plate and the rear plate and including at least one neck portion disposed between the first electronic component and the second electronic component; a rear case disposed between the circuit board and the rear plate and having at least one conductive layer formed on one side facing one side of the circuit board; a metal supporting plate supporting the at least one neck portion and disposed on the one side of the circuit board; and a conductive body electrically connecting the supporting plate and the conductive layer of the rear case and disposed on the supporting plate. In addition, various embodiments understood through the specification may also be possible.

## Description

### [Technical Field]

The disclosure relates to an electronic device including a conductive structure according to an embodiment.

### [Background Art]

A typical electronic device may have at least one circuit board disposed in a housing. For example, the circuit board disposed in the housing may be at least one circuit board formed of a rigid material or at least one circuit board formed of a flexible material. For example, rigid circuit boards spaced apart from each other may be electrically connected using a flexible circuit board.

In addition, the electronic device may include a main circuit board and at least one sub circuit board in the housing. A plurality of electronic components for performing functions of the electronic device may be disposed on one side and/or the other side of the circuit board.

When the circuit board is disposed in the housing, a metal plate may be disposed on one side of the circuit board to support a disposition state of the circuit board or to reinforce rigidity of the circuit board. The circuit board may use a separate conductive component, such as a clip, to establish electrical connection with a conductive layer. The separate conductive component may be disposed at a position spaced apart from the metal plate disposed on the circuit board, or may be disposed on the other side of the circuit board, which is opposite to one side on which a supporting plate is disposed.

The foregoing information may be provided as the related art for purposes of helping understanding of the disclosure. No claim or decision is made as to whether the foregoing content is applicable as the prior art related to the disclosure.

### [Disclosure of Invention]

### [Solution to Problem]

When a connection terminal (e.g., a conductive clip), which is a conductive component, is disposed at a position adjacent to but spaced apart from a metal plate disposed on one side of a circuit board, stress may occur in a neck portion of the circuit board due to the connection terminal, thereby causing a crack in the circuit board.

In addition, when a separate conductive component is disposed on the other side of the circuit board, a space for disposing other components may be reduced, which may result in poor mountability of the components. For example, it may be difficult to dispose a chip such as a Hall sensor due to an insufficient wiring width.

In addition, when the connection terminal (e.g., the conductive clip), which is the conductive component, is disposed to electrically connect the circuit board to a radiator adjacent to a metal plate disposed on one side of the circuit board, antenna performance may be degraded due to noise produced in the circuit board.

Technical problems to be solved in the disclosure are not limited to the technical problems mentioned above, and other technical problems not mentioned herein may be clearly understood by those skilled in the art to which the disclosure pertains from the following descriptions.

As technical means for achieving the above-described technical problem, one aspect of the disclosure provides an electronic device including a conductive structure configured to improve rigidity of a circuit board having a relatively narrow width, grounding stability, and mountability with other components.

In addition, another aspect of the disclosure provides an electronic device including a conductive structure configured to improve rigidity of a circuit board having a relatively narrow width, grounding stability, and antenna radiator performance.

In addition, still another aspect of the disclosure provides an electronic device including a conductive structure configured to improve rigidity of a circuit board having a relatively narrow width, antenna radiator performance, grounding stability, and electromagnetic shielding.

In addition, still another aspect of the disclosure provides an electronic device including a conductive structure configured to prevent interference between first and second electronic components disposed on opposite sides of a circuit board having a relatively narrow width.

An electronic device according to an embodiment may include a housing including a front plate, a rear plate, and a lateral member surrounding at least part of an inner space between the front plate and the rear plate. The housing may include: a first electronic component disposed in the housing; a second electronic component spaced apart from the first electronic component and disposed in the housing; and a circuit board disposed between the front plate and the rear plate and including at least one neck portion disposed between the first electronic component and the second electronic component. The housing may include a rear case disposed between the circuit board and the rear plate and having at least one conductive layer formed on one side facing one side of the circuit board. The housing may include: a metal supporting plate supporting the at least one neck portion and disposed on the one side of the circuit board; and a conductive body electrically connecting the supporting plate and the conductive layer of the rear case and disposed on the supporting plate.

According to an embodiment, an electronic device may include a circuit board including: a first electronic component disposed on one side; a second electronic component spaced apart from the first electronic component; and at least one neck portion disposed between the first electronic component and the second electronic component. The electronic device may include a rear case disposed to face the circuit board and having at least one conductive layer formed on one side facing one side of the circuit board. A conductive structure according to an embodiment may include: a supporting plate supporting the at least one neck portion and disposed on one side of the circuit board; and a conductive body electrically connecting the supporting plate and the conductive layer and disposed on the supporting plate.

According to an embodiment, the disclosure may use a conductive structure to enable reinforcement of rigidity of a neck portion of a circuit board, grounding stability, prevention of interference between electronic components, and improvement of antenna performance.

Advantages acquired in the disclosure are not limited to the aforementioned advantages, and other advantages not mentioned herein may be clearly understood by those skilled in the art to which the disclosure pertains from the following descriptions.

### [Brief Description of Drawings]

FIG. 1 illustrates an example of an external appearance of an electronic device in an unfolded state according to an embodiment;
FIG. 2 illustrates an example of an external appearance of an electronic device in a folded state according to an embodiment;
FIG. 3 is an exploded perspective view illustrating an example of an electronic device according to an embodiment;
FIG. 4 is a plan view illustrating a neck portion of a circuit board located between first and second electronic components according to an embodiment;
FIG. 5 is a cross-sectional view illustrating a conductive structure disposed to a neck portion of various circuit boards according to an embodiment;
FIG. 6 is a cross-sectional view illustrating a conductive structure disposed to a neck portion of various circuit boards according to an embodiment;
FIG. 7 is a cross-sectional view illustrating a conductive structure disposed to a neck portion of various circuit boards according to an embodiment;
FIG. 8 is a cross-sectional view illustrating a conductive structure disposed to a neck portion of various circuit boards according to an embodiment;
FIG. 9 is a cross-sectional view illustrating a state in which various conductive structures are electrically connected to a conductive layer according to an embodiment;
FIG. 10 is a cross-sectional view illustrating a state in which various conductive structures are electrically connected to a conductive layer according to an embodiment;
FIG. 11 is a cross-sectional view illustrating a state in which various conductive structures are electrically connected to a conductive layer according to an embodiment;
FIG. 12 is a cross-sectional view illustrating a state in which various conductive structures are electrically connected to a conductive layer according to an embodiment;
FIG. 13 is a cross-sectional view illustrating a conductive structure having a shielding function according to an embodiment;
FIG. 14 is a cross-sectional view illustrating a conductive structure having a shielding function according to an embodiment;
FIG. 15 is a cross-sectional view illustrating a conductive structure disposed to a non-neck portion of various circuit boards according to an embodiment;
FIG. 16A is a plan view illustrating a state in which a conductive structure is disposed adjacent to an antenna feeding portion according to an embodiment;
FIG. 16B is a lateral view illustrating a state in which a conductive structure is disposed to a neck portion according to an embodiment;
FIG. 16C is a comparative graph illustrating radiation efficiencies of a conductive structure according to a comparative example and a conductive structure according to an embodiment, respectively;
FIG. 17 is a comparative exemplary view illustrating stresses occurring at a conductive structure according to a comparative example and at a neck portion of conductive structure according to an embodiment; and
FIG. 18 is a plan view illustrating a circuit board and a ground portion formed on a neck portion of the circuit board according to an embodiment.

With regard to the description of the drawings, the same or similar reference numerals may be used to refer to the same or similar elements.

### [Mode for the Invention]

Hereinafter, embodiments of the disclosure will be described in detail with reference to the accompanying drawings so that those skilled in the art can easily implement the disclosure. However, the disclosure may be realized in various different forms and is not limited to the embodiments described herein. In addition, in order to clearly describe the disclosure, parts not related to the description are omitted in the drawings, and similar reference numerals are given to similar parts throughout the specification.

Terms used in the disclosure are described as general terms currently in use in consideration of functions mentioned in the disclosure, but may mean various other terms depending on the intention of a technician engaged in the relevant field, precedents, emergence of new technologies, or the like. Therefore, the terms used in the disclosure shall not be interpreted only based on the name of the term, but shall be interpreted based on the meaning of the term and the overall content of the disclosure.

In addition, the terms '1st', '2nd', or the like may be used to describe various elements, but the elements shall not be limited by these terms. The terms are used to distinguish one element from another.

Throughout the specification, when a part is mentioned to be "connected" to another part, this includes not only a case where it is "directly connected" but also a case where it is "electrically connected" thereto with other elements interposed therebetween. Also, when a part is mentioned to "include" an element, this does not mean that it excludes other elements, but rather that it may further include other elements, unless otherwise specified.

Phrases such as "in an embodiment" mentioned in various sections of the disclosure do not necessarily all refer to the same embodiment.

An embodiment of the disclosure may be represented by functional block configurations and various processing steps. Some or all of these functional blocks may be implemented as various hardware and/or software components which perform specific functions. For example, the functional blocks of the disclosure may be implemented by one or more microprocessors, or may be implemented by circuit configurations designed for specific functions. Further, for example, the functional blocks of the disclosure may be implemented as various programming or scripting languages. The functional blocks may also be implemented as algorithms executed on one or more processors. Furthermore, the disclosure may employ the prior art for electronic environment configurations, signal processing, and/or data processing. Terms such as "mechanism," "element," "means," and "configuration" are used broadly herein, and are not limited to mechanical or physical configurations.

In addition, connecting lines or connecting members between elements shown in the drawings are provided merely as examples of functional connections and/or physical or circuit connections. In actual devices, the connections between the elements may be implemented by various alternative or additional functional, physical, or circuit connections.

Hereinafter, the disclosure will be described in detail with reference to the accompanying drawings.

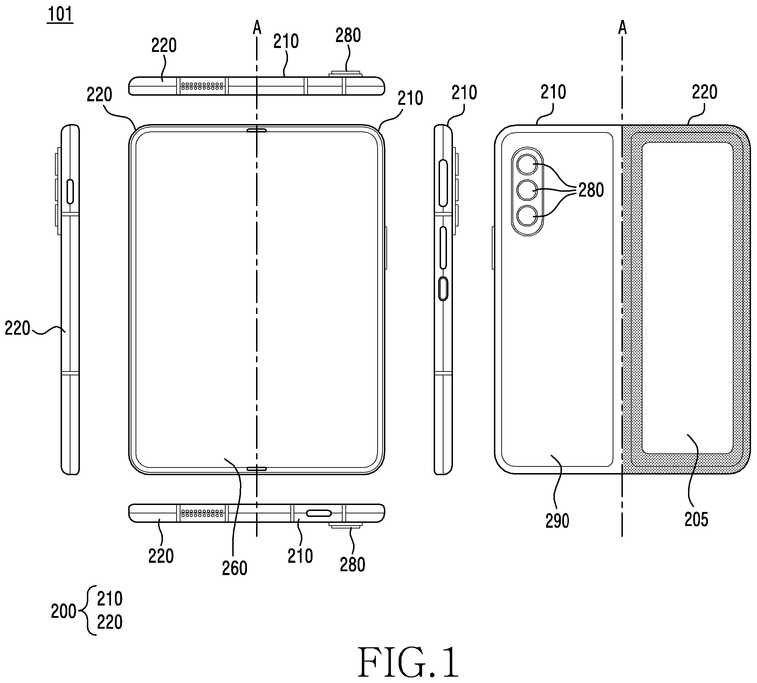

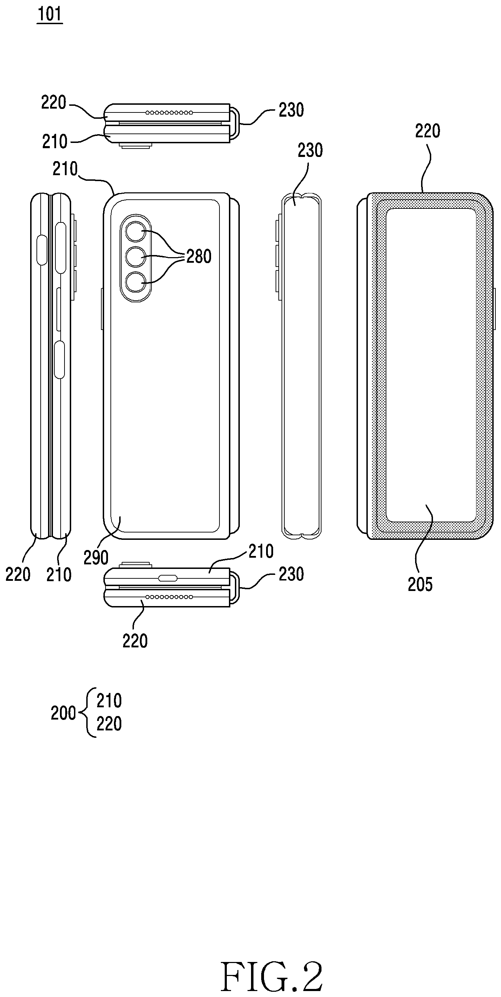

FIG. 1 illustrates an example of an external appearance of an electronic device 101 in an unfolded state according to an embodiment. FIG. 2 illustrates an example of an external view of the electronic device 101 in a folded state according to an embodiment.

Referring to FIG. 1 and FIG. 2, in an embodiment, the electronic device 101 may include a foldable housing 200, a folding portion 230 (e.g., a hinge and a hinge cover) covering a foldable portion of the foldable housing 200, and a flexible display 260 disposed in a space formed by the foldable housing 200. In the disclosure, a side on which the flexible display 260 is disposed may be referred to as a front side of the electronic device 101. In the disclosure, a side opposite to the front side may be referred to as a rear side. In the disclosure, a side surrounding a space between the front side and the rear side may be referred to as a lateral side of the electronic device 101. According to an embodiment, the electronic device 101 may include a front plate facing a first direction (e.g., an upward direction) and forming the front side of the electronic device 101, a rear plate (e.g., a rear cover) facing a second direction opposite to the first direction (e.g., a downward direction) and forming the rear side of the electronic device 101, and a lateral member (e.g., a bezel structure) facing a third direction (e.g., a lateral direction) perpendicular to each of the first and second directions and surrounding at least part of a space between the front plate and the rear plate.

In an embodiment, the foldable housing 200 may include a first housing structure 210 and a second housing structure 220. The first housing structure 210 may also be referred to as a first housing. The second housing structure 220 may also be referred to as a second housing. The first housing structure 210 may include a rear cover 290. The foldable housing 200 of the electronic device 101 is not limited to the configuration and coupling illustrated in FIG. 1 and FIG. 2, and may be implemented by other shapes or combinations and/or couplings of components. For example, in an embodiment, the first housing structure 210 and the rear cover 290 may be integrally formed.

According to an embodiment, the first housing structure 210 and the second housing structure 220 may be disposed on opposite sides with respect to a folding axis A, and may have shapes of which lateral sides are symmetrical with respect to the folding axis A. As described below, depending on an angle or a distance between the first housing structure 210 and the second housing structure 220, a state of the electronic device 101 may be referred to as an unfolded state (a flat/open state) (e.g., FIG. 1), a folded state (e.g., FIG. 2), or an intermediate state. In an embodiment, the first housing structure 210 and the second housing structure 220 may have generally symmetrical shapes, while portions thereof may have different shapes from each other.

Referring to FIG. 1, the first housing structure 210 may include the rear cover 290 on which at least one camera 280 is disposed. The second housing structure 220 may include a structure in which a display 205 is disposed on a rear side thereof.

According to an embodiment, the first housing structure 210 and the second housing structure 220 may together form a shape of accommodating the flexible display 260. The rear cover 290 may be disposed on one side of the folding axis A at the rear side of the electronic device 101. A periphery of the rear cover 290 may be surrounded by the housing structure 210.

In an embodiment, the first housing structure 210 and the second housing structure 220 may form a space capable of disposing components (e.g., a printed circuit board, a battery) of the electronic device 101. In an embodiment, one or more components or sensors may be disposed on the rear side of the electronic device 101, or may be visually exposed. For example, lenses of the at least one camera 280 may be visually exposed through the rear cover 290.

Referring to FIG. 2, in an embodiment, the folding portion 230 may be disposed between the first housing structure 210 and the second housing structure 220, and may be configured to have an internal component (e.g., a hinge structure). In an embodiment, the folding portion 230 may be covered, or exposed externally, at least in part by the first housing structure 210 and the second housing structure 220, depending on the state (e.g., the unfolded state, the folded state, or the intermediate state) of the electronic device 101.

For example, when the electronic device 101 is in the unfolded state as illustrated in FIG. 1, the folding portion 230 may be covered by at least one of the first housing structure 210 and the second housing structure 220 and thus may not be visually exposed. For example, when the electronic device 101 is in the folded state (e.g., a fully folded state) as illustrated in FIG. 2, the folding portion 230 may be visually exposed externally at least in part between the first housing structure 210 and the second housing structure 220. For example, when the first housing structure 210 and the second housing structure 220 are folded with a certain angle, i.e., in the intermediate state, the folding portion 230 may be exposed externally at least in part between the first housing structure 210 and the second housing structure 220. For example, a region in which the folding portion 230 is exposed may be smaller than in the fully folded state. In an embodiment, the exposed region of the folding portion 230 may include a curved surface.

In an embodiment, the flexible display 260 may be disposed in a space formed by the foldable housing 200. For example, at least part of the flexible display 260 may be disposed along a first side defined along the first housing structure 210 and a second side defined along the second housing structure 220. The rear side of the electronic device 101 may include the rear cover 290 and the display 205.

In an embodiment, the flexible display 260 may include a display in which at least some regions thereof are deformed to a planar or curved surface. The flexible display 260 may be divided into a plurality of regions according to structural functions.

In an embodiment, when the electronic device 101 is in the unfolded state (e.g., FIG. 1), a first side on which the flexible display 260 is disposed at the first housing structure 210 and a second side on which the flexible display 260 is disposed at the second housing structure 220 may form an angle of approximately 180 degrees. In the flexible display 260, a region corresponding to the first housing structure 210 and a region corresponding to the second housing structure 220 may face substantially the same direction. When the electronic device 101 is in the unfolded state, a side on which the flexible display 260 is disposed may be referred to as a forward direction of the electronic device 101.

In an embodiment, when the electronic device 101 is in the folded state (e.g., FIG. 2), the first housing structure 210 and the second housing structure 220 may be disposed to face each other. In the flexible display 260, a first side disposed at the first housing structure 210 and a second side disposed at the second housing structure 220 may form a narrow angle (e.g., an angle greater than or equal to 0 degrees and less than or equal to 10 degrees). The first side and the second side may face each other. Some regions of the flexible display 260 disposed between the first side and the second side may be deformed to a shape having a predetermined curvature.

In an embodiment, when the electronic device 101 is in the intermediate state, the first housing structure 210 and the second housing structure 220 may be disposed with a certain angle with respect to each other. In the flexible display 260, a first side disposed at the first housing structure 210 and a second side disposed at the second housing structure 220 may form an angle greater than the angle formed in the folded state and smaller than the angle formed in the unfolded state. Some regions of the flexible display 260 disposed between the first side and the second side may be deformed to a shape having a predetermined curvature. A curvature of some regions of the flexible display 260 in the intermediate state may be smaller than a curvature in the folded state.

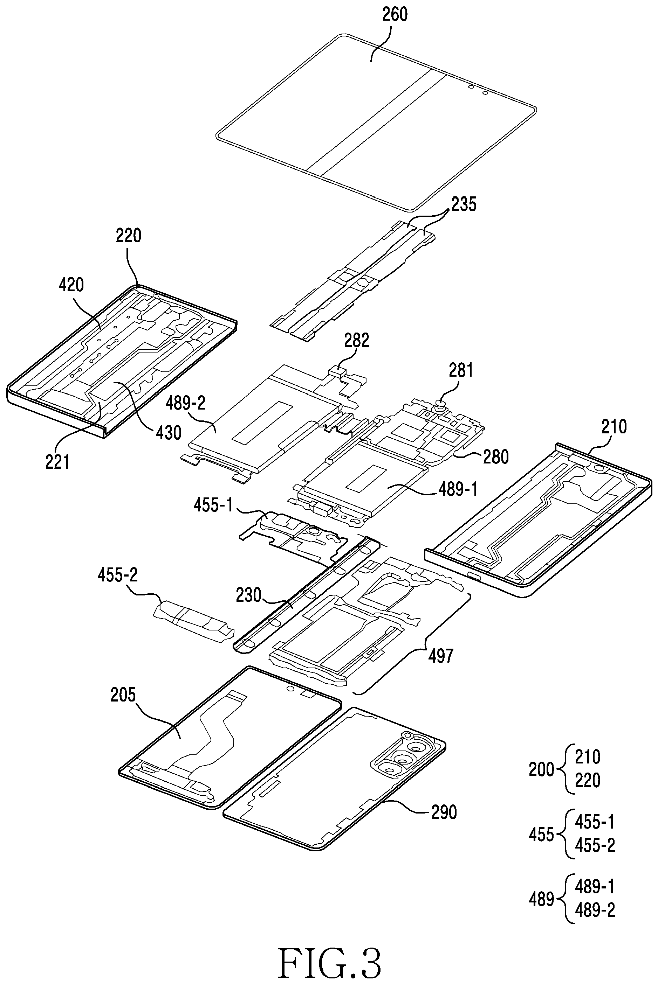

FIG. 3 is an exploded perspective view illustrating an example of an electronic device 101 according to an embodiment.

In an embodiment, the electronic device 101 may include a flexible display 260, a first housing 210, a second housing 220, batteries 489-1 and 489-2, a folding portion 230, at least one plate 235, at least one camera 280, a front camera 281, a rear camera 282, a speaker module 455, an antenna module 497, a display 205, and a rear cover 290.

In an embodiment, the at least one plate 235 may be disposed at a position corresponding to a region where the flexible display 260 bends as the first housing 210 and the second housing 220 are folded. The at least one plate 235 may move within the electronic device 101 along with a change in an angle between the first housing 210 and the second housing 220. The at least one plate 235 may be disposed to support the flexible display 260 when the electronic device 101 is in a certain state (.e.g., an unfolded state). The flexible display 260 may be fixed at least in part to the first housing 210, and at least some of the remaining part may be fixed to the second housing 220.

In an embodiment, the first housing 210 may include a bracket (or a frame) for disposing elements of the electronic device 101. The bracket disposed at the first housing 210 may be integrally formed with the first housing 210, or may be fixed to the first housing 210 as a separate element. Referring to FIG. 3, at least one of the cameras 280 (e.g., the camera 280 of FIG. 1 and FIG. 2), which are exposed to a rear side of the electronic device 101, the front camera 281, the battery 489-1, and the antenna module 497 may be disposed based on the bracket of the first housing 210. The at least one of the cameras 280 may be optically exposed at least in part through the rear cover 290. The front camera 281 may be disposed to receive light through a region (e.g., a hole region or a notch region) formed transparently on the flexible display 260. Alternatively, the front camera 281 may include an under-display camera (UDC) which receives light through the flexible display 260 without a separate transparent region. The battery 489-1 may store power and supply the stored power to at least one element included in the electronic device 101. The antenna module 497 may include at least one antenna or at least one radio frequency integrated circuit (RFIC) for performing communication. For example, the antenna module 497 may include at least one of a main antenna, a sub-antenna, an antenna for performing ultra-wide band (UWB) communication, or an antenna for performing near field communication (NFC). Referring to FIG. 3, at least one of the cameras 280, the front camera 281, the battery 489-1, and the antenna module 497 may be disposed in a space surrounded at least in part by the first housing 210, the flexible display 260, and the rear cover 290.

In an embodiment, the second housing 220 may include a bracket (or a frame 221) for disposing elements of the electronic device 101. The bracket disposed at the second housing 220 may be integrally formed with the first housing 210, or may be fixed to the first housing 210 as a separate element. Referring to FIG. 3, the rear camera 282, the battery 489-2, the speaker module 455, an adhesive member 420, and a first cushioning member 430 may be disposed based on the bracket 221 of the second housing 220. The rear camera 282 may be disposed to receive light through a region (e.g., a hole region or a notch region) formed transparently on the display 205. The rear camera 282 may also include a UDC which receives light through the display 205. The battery 489-2 may store power and supply the stored power to at least one element of the electronic device 101. The speaker module 455 may include at least one speaker for outputting sound. For example, the speaker module 455 may include an upper speaker 455-1 which outputs sound through an upper end (e.g., a region of the second housing 220, adjacent to the rear camera 282). The speaker module 455 may include a lower speaker 455-2 which outputs sound through a lower end (opposite to the upper end) of the electronic device 101. The adhesive member 420 may be attached to the flexible display 260 and the bracket 221 to form a waterproof region, which is a space for preventing liquid from entering from the outside, between the flexible display 260 and the bracket 221. The adhesive member 420 may include, for example, waterproof tape. The first cushioning member 430 may include a material which alleviates impact caused when the flexible display 260 collides with the bracket 221 formed of a rigid material. For example, the first cushioning member 430 may include at least one of a porous foam and an elastomer. Referring to FIG. 3, the rear camera 282, the battery 489-2, the speaker module 455, the adhesive member 420, and the first cushioning member 430 may be disposed in a space surrounded at least in part by the second housing 220, the display 205, and the flexible display 260.

In an embodiment, the folding portion 230 may include a hinge structure configured to rotatably connect the first housing 210 and the second housing 220, a hinge cover disposed to prevent the hinge structure from being exposed to the outside, and at least one of the plates 235 connected to the hinge structure.

However, the elements and the disposition of the elements illustrated in FIG. 3 are provided merely to describe an example, and some elements may be modified or repositioned. For example, although it is shown in FIG. 3 that the front camera 281 is disposed at the first housing 210 and the rear camera 282 is disposed at the second housing 220; the front camera 281 may be disposed at the second housing 220 and the rear camera 282 may be disposed at the first housing 210.

Hereinafter, a conductive structure according to various embodiments will be described with reference to the drawings.

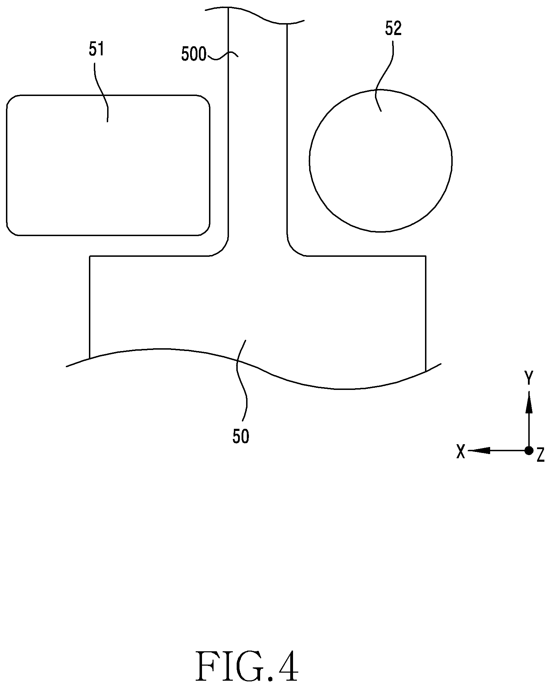

FIG. 4 is a plan view illustrating a neck portion of a circuit board located between first and second electronic components according to an embodiment.

An orthogonal coordinate system is illustrated in FIG. 4, in which an X-axis represents a horizontal direction of a housing, a Y-axis represents a vertical direction of the housing, and a Z-axis represents a height direction of the housing.

Referring to FIG. 4, an electronic device according to an embodiment may include at least one circuit board 50 disposed in the housing (e.g., the foldable housing 200 of FIG. 1). According to an embodiment, the circuit board 50 may be formed of a plurality of layers, and may be formed of a rigid material or a flexible material. According to an embodiment, a plurality of electronic components may be disposed on one side of the circuit board 50, and a plurality of electronic components may be disposed on the other side opposite to the one side. According to an embodiment, the plurality of electronic components may include a first electronic component 51 disposed on the one side, and a second electronic component 52 disposed on the one side, spaced apart from the first electronic component 51 and located adjacent thereto. For example, the first electronic component 51 may include any one of a camera module and a motor, and the second electronic component 52 may include any one of a speaker, a microphone, a display driver IC (DDI), an application processor (AP), a low-noise amplifier (LNA), and a filter. According to an embodiment, the first and second electronic components 51 and 52 may be disposed on the circuit board 50, or may not be disposed on the circuit board 50. For example, the first and second electronic components 51 and 52 may be disposed in the housing, not on the circuit board.

According to an embodiment, the circuit board 50 may include at least one neck portion 500. According to an embodiment, the neck portion 500 is a portion disposed between the first and second electronic components 51 and 52 disposed on one side of the circuit board 50, and is a portion of which a width is relatively sharply reduced, and thus may be more vulnerable to cracking than a portion having a relatively larger width. According to an embodiment, a length of the neck portion 500 of the circuit board disposed in the housing is not limited, and may be optionally formed to have a short length or a long length.

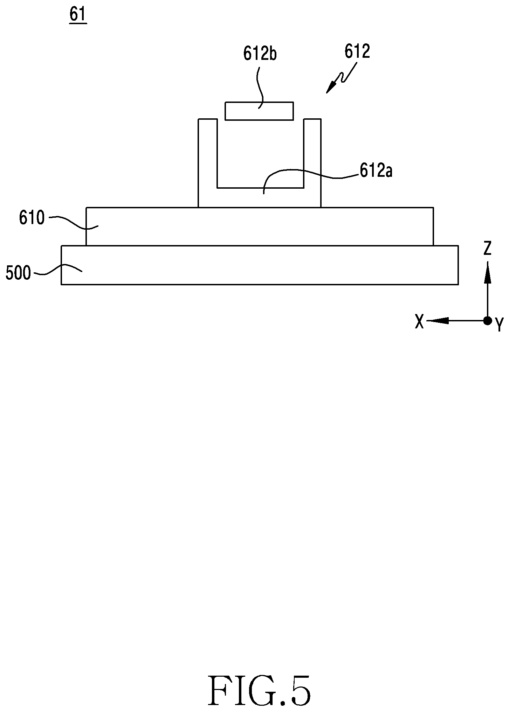

According to an embodiment, a supporting plate (e.g., a supporting plate 610 of FIG. 5) may be additionally provided to the neck portion 500 to reinforce rigidity. According to an embodiment, the supporting plate may be attached to one side of the neck portion 500 to support the neck portion 500 and reinforce rigidity of the neck portion 500.

FIG. 5 to FIG. 8 are cross-sectional views each illustrating a conductive structure disposed to a neck portion of various circuit boards according to an embodiment.

Referring to FIG. 5, according to an embodiment, an electronic device (e.g., the electronic device 101 of FIG. 1) may include a conductive structure 61 disposed to reinforce rigidity of a neck portion 500 of a circuit board and to provide electrical connection with a conductive layer (e.g., an antenna radiator or a ground portion).

According to an embodiment, the conductive structure 61 may be a metal structure which supports the neck portion 500 of the circuit board, shields interference between first and second electronic components 51 and 52, is operable as a ground portion by being connected to the ground portion of the circuit board, and is electrically connected to a different conductive layer (e.g., an antenna radiator) or is operable as an antenna radiator. According to an embodiment, the conductive structure 61 may include a supporting plate 610 and a conductive body 612. According to an embodiment, the conductive structure 61 may be disposed on the circuit board (e.g., the circuit board 50 of FIG. 4) as a surface mounting device (SMD).

According to an embodiment, the conductive structure 61 may serve as a reinforcing member for preventing damage to the circuit board 50, and, from an electrical perspective, may be utilized as a critical contact point (CCP), general antenna feeding, or a coaxial connector.

According to an embodiment, the supporting plate 610 may be a thin plate formed of a metal material, and may be bonded to one side of the neck portion 500 of the circuit board (e.g., the circuit board 50 of FIG. 4). For example, the supporting plate 610 may be formed of stainless steel (SUS). According to an embodiment, the supporting plate 610 may be bonded to a ground portion formed on the circuit board (e.g., the circuit board 50 of FIG. 4). For example, the ground portion may be formed in a patterned shape on one side of the circuit board 50.

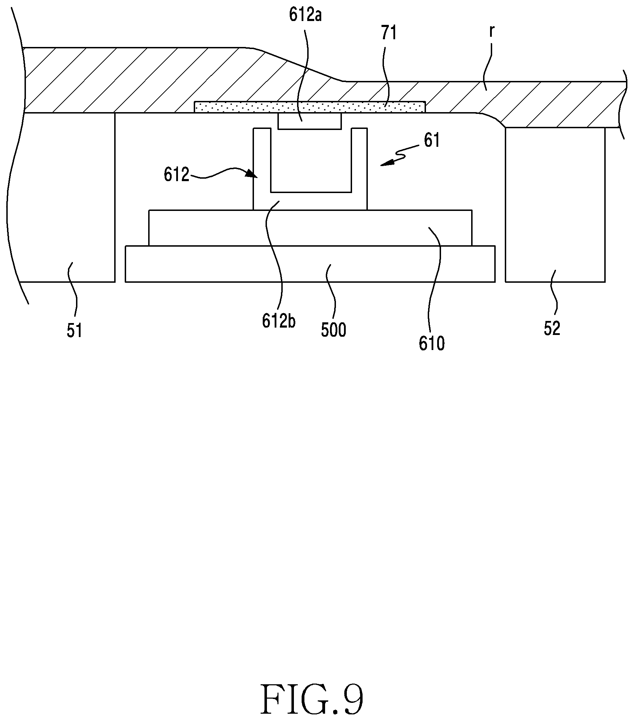

According to an embodiment, the conductive body 612 may be integrally formed with the supporting plate 610. However, the disclosure is not limited thereto, and the conductive body 612 may be separately manufactured and connected to the supporting plate 610. According to an embodiment, the conductive body 612 may be a conductive portion for electrically connecting the supporting plate 610 to a conductive layer. For example, the conductive layer may be any one of an antenna radiator formed on a rear case (e.g., a rear case r of FIG. 9) and a portion of a housing formed of a metal material. According to an embodiment, when the conductive structure 61 is electrically connected to the housing formed of the metal material, such a connection structure may be used to enhance a grounding function between the circuit board 50 and the housing.

According to an embodiment, the conductive body 612 may be a clip-shaped connection terminal, in which one end portion 612a may be a fixed portion and another end portion 612b may be an elastic portion. According to an embodiment, the conductive body 612 may be a portion in which the one end portion 612a is electrically connected to the supporting plate 610 and the other end portion 612b is elastically and electrically connected to a different conductive layer. For example, the conductive body may be any one of a C-clip and a finger clip.

According to an embodiment, in a top view above the supporting plate 610 (e.g., in a Z-axis direction), the conductive body 612 and the supporting plate 610 may be disposed to overlap at least in part each other. In addition, according to an embodiment, in the top view above the supporting plate 610, the neck portion 500, the supporting plate 610, and the conductive body 612 may be disposed to overlap at least in part each other. For example, the overlapping may occur along a vertical direction (e.g., the Z-axis direction).

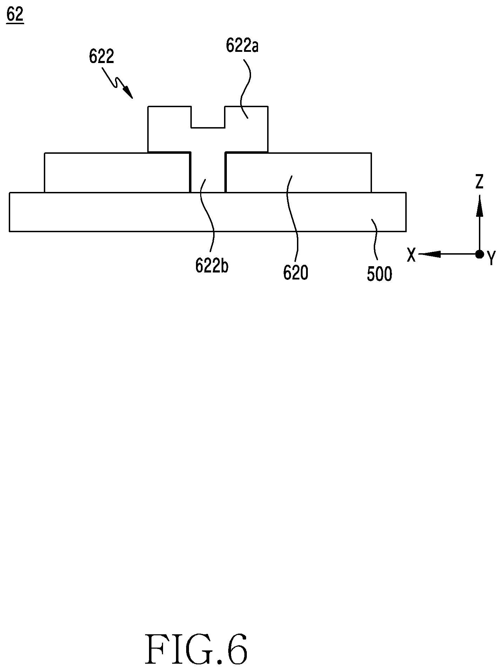

Referring to FIG. 6, according to an embodiment, an electronic device (e.g., the electronic device 101 of FIG. 1) may include a conductive structure 62 disposed to reinforce rigidity of a neck portion 500 of a circuit board (e.g., the circuit board 50 of FIG. 4) and to electrically connect to a conductive layer. According to an embodiment, the conductive structure 62 may include a supporting plate 620 and a conductive body 622.

According to an embodiment, the supporting plate 620 may be a thin plate formed of a metal material, and may be disposed on or bonded to one side of the neck portion 500. According to an embodiment, the supporting plate 620 may be bonded to a ground portion formed on a circuit board (e.g., the circuit board 50 of FIG. 4). For example, the ground portion may be formed in a patterned shape on one side of the circuit board (e.g., the circuit board 50 of FIG. 4).

According to an embodiment, the conductive body 622 may be inserted at least in part into the supporting plate 620, and may be electrically connected to the neck portion 500 of the circuit board. According to an embodiment, the conductive body 622 may be a conductive portion for electrically connecting the neck portion 500 of the circuit board to a different conductive layer. For example, the conductive layer may be an antenna radiator or a ground portion, formed on a rear case (e.g., a rear case r of FIG. 9).

According to an embodiment, the conductive body 622 may have a flat fastener shape, with a first end 622a electrically connected to a different conductive layer and a second end 622b electrically connected to the neck portion 500 of the circuit board. According to an embodiment, the second end 622b may be formed as a protruding shape extending upright from the first end 622a. According to an embodiment, the conductive body 622 may be electrically connected to the supporting plate 620, or may be insulated from the supporting plate 620.

According to an embodiment, in a top view above the supporting plate 620 (e.g., in a Z-axis direction), the conductive body 622 and the supporting plate 620 may be disposed to overlap at least in part each other. In addition, according to an embodiment, the neck portion 500, the supporting plate 620, and the conductive body 622 may be disposed to overlap at least in part each other. For example, the overlapping may occur along a vertical direction (e.g., the Z-axis direction).

According to an embodiment, the conductive structure 62 may be disposed on the circuit board 50 as an SMD.

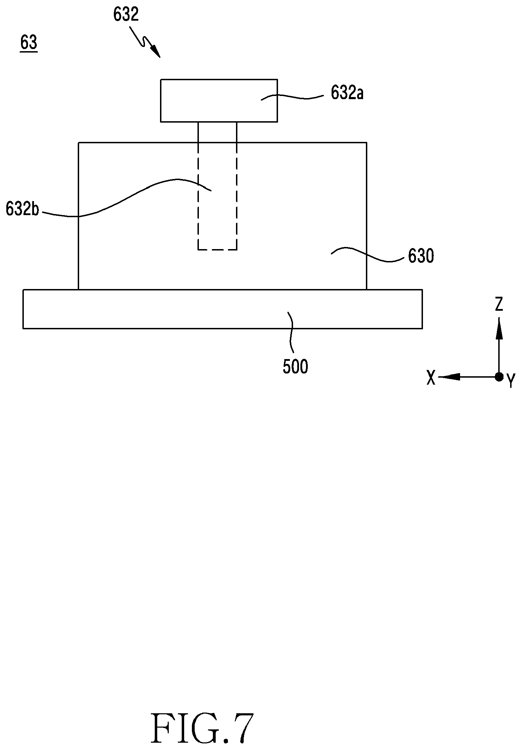

Referring to FIG. 7, according to an embodiment, an electronic device (e.g., the electronic device 101 of FIG. 1) may include a conductive structure 63 disposed to reinforce rigidity of a neck portion 500 of a circuit board (e.g., the circuit board 50 of FIG. 4) and to electrically connect to a conductive layer. According to an embodiment, the conductive structure 63 may include a supporting plate 630 and a conductive body 632.

According to an embodiment, the supporting plate 630 may be a thin plate formed of a metal material, and may be at least in part disposed on or bonded to one side of the neck portion 500. According to an embodiment, the supporting plate 630 may be bonded to a ground portion formed on a circuit board (e.g., the circuit board 50 of FIG. 4). For example, the ground portion may be formed at least in part in a patterned shape on one side of the circuit board.

According to an embodiment, the conductive body 632 may be fastened to the supporting plate 630. According to an embodiment, the conductive body 632 may be a conductive portion configured to electrically connect the supporting plate 630 to a different conductive layer. For example, the different conductive layer may be an antenna radiator formed on a rear case.

According to an embodiment, the conductive body 632 may have a metal fastener shape, such as a screw. According to an embodiment, the conductive body 632 may include a head portion 632a and a threaded portion 632b. According to an embodiment, the threaded portion 632b of the conductive body 632 may penetrate a conductive layer and be fastened to the supporting plate 630. The conductive layer (e.g., an antenna radiator) and the supporting plate 630 may be electrically connected through the conductive body 632, such that the supporting plate 630 may be utilized as part of the antenna radiator. According to an embodiment, the supporting plate 630 may be relatively thick to accommodate fastening of the threaded portion 632b of the conductive body.

According to an embodiment, in a top view above the supporting plate (e.g., in a Z-axis direction), the conductive body 632 and the supporting plate 630 may be disposed to overlap at least in part each other. In addition, according to an embodiment, the neck portion 500, the supporting plate 630, and the conductive body 632 may be disposed to overlap at least in part each other. For example, in the overlapping structure, overlapping may occur at least in part along a vertical direction (e.g., an up-down direction) (e.g., the Z-axis direction).

According to an embodiment, the conductive structure 63 may be disposed on the circuit board 50 as an SMD.

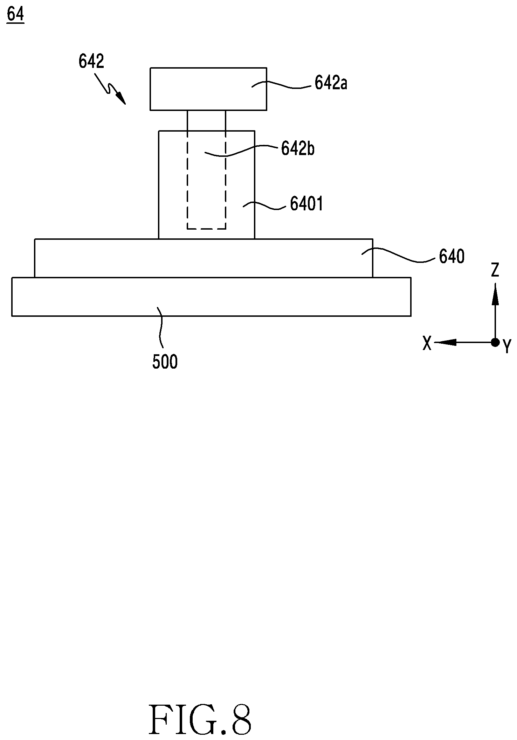

Referring to FIG. 8, according to an embodiment, an electronic device (e.g., the electronic device 101 of FIG. 1) may include a conductive structure 64 disposed to reinforce rigidity of a neck portion 500 of a circuit board (e.g., the circuit board 50 of FIG. 4) and to electrically connect to a conductive layer. According to an embodiment, the conductive structure 64 may include a supporting plate 640 and a conductive body 642.

According to an embodiment, the supporting plate 640 may be a thin plate formed of a metal material, and may be at least in part disposed on or bonded to one side of the neck portion 500 of the circuit board (e.g., the circuit board 50 of FIG. 4). According to an embodiment, the supporting plate 640 may be bonded to a ground portion formed on the circuit board (e.g., the circuit board 50 of FIG. 4). For example, the ground portion may be formed in a patterned shape on one side of the circuit board.

According to an embodiment, the conductive body 642 may be physically fastened to the supporting plate 640. According to an embodiment, the conductive body 642 may serve as a conductive portion configured to electrically connect the supporting plate 640 to a different conductive layer. For example, the different conductive layer may be an antenna radiator formed on a rear case (e.g., the rear case r of FIG. 9). According to an embodiment, the conductive body 642 may include metal fasteners 642a and 642b and a fastening portion 6401. According to an embodiment, the metal fasteners 642a and 642b may have a shape such as a screw.

According to an embodiment, the metal fastener may include a head portion 642a and a threaded portion 642b. According to an embodiment, the threaded portion 642b of the conductive body 642 may penetrate the different conductive layer, and may be fastened to the fastening portion 6401. The different conductive layer and the supporting plate 640 may be electrically connected by the conductive body 642.

According to an embodiment, the fastening portion 6401 may be integrally formed on the supporting plate 640 with the same material. For example, the fastening portion 6401 may have a cylindrical shape, and the threaded portion 642b may be fastened in an inner space.

According to an embodiment, the conductive body 642 and the supporting plate 640 may be disposed to overlap at least in part each other. In addition, according to an embodiment, the neck portion 500, the supporting plate 640, and the conductive body 642 may be disposed to overlap at least in part each other. For example, in the overlapping structure, overlapping may occur at least in part along a vertical direction (e.g., an up-down direction) (e.g., a Z-axis direction).

According to an embodiment, the conductive structure 64 may be disposed on the circuit board 50 as an SMD.

FIG. 9 to FIG. 12 are cross-sectional views each illustrating a state in which various conductive structures are electrically connected to a conductive layer according to an embodiment.

Referring to FIG. 9, according to an embodiment, the conductive structure 61 of FIG. 5 may be electrically connected to a conductive layer 71 formed on a rear case r. According to an embodiment, a conductive body 612 may electrically connect the conductive layer 71 and a supporting plate 610. According to an embodiment, one end portion 612a of the conductive body 612 may elastically maintain a contact state with the conductive layer 71. For example, the conductive layer 71 may include an antenna radiator. Hereinafter, the conductive layer 71 will be referred to as an antenna radiator 71. According to an embodiment, the conductive structure 61 may electrically connect a circuit board 50 and the conductive layer 71, and thus may be used as a feeding portion of the conductive layer 71.

According to an embodiment, the supporting plate 610 may be grounded to one side of a neck portion 500 of the circuit board (e.g., the circuit board 50 of FIG. 4), thereby supporting the neck portion 500 of the circuit board while being grounded to the circuit board. According to an embodiment, the conductive body 612 of the conductive structure 61 may electrically connect the antenna radiator 71 and the supporting plate 610, thereby being utilized as part of the antenna radiator 71.

For example, the antenna radiator 71 may include any one of types of a radiator formed in a patterned shape, an antenna disposed in a patch type, and a laser direct structuring (LDS) antenna. The connection structure between the conductive structure 61 and the antenna radiator 71 may be advantageous in saving a component mounting space, and may enable implementation of a stable electrical connection.

According to an embodiment, the conductive structure 61 may electrically connect the circuit board (e.g., the circuit board 50 of FIG. 4) and the conductive layer 71, thereby being used as a feeding portion of the conductive layer 71. According to an embodiment, when the conductive structure 61 is used as the feeding portion of the conductive layer 71, a copper layer (e.g., a ground portion) of the circuit board 50 may be removed, such that the conductive structure 61 may operate as an antenna radiator.

According to an embodiment, the conductive structure 61 may be used as an antenna tuning point for optimizing antenna performance by partially changing a shape and a material thereof (e.g., changing an antenna resonance point).

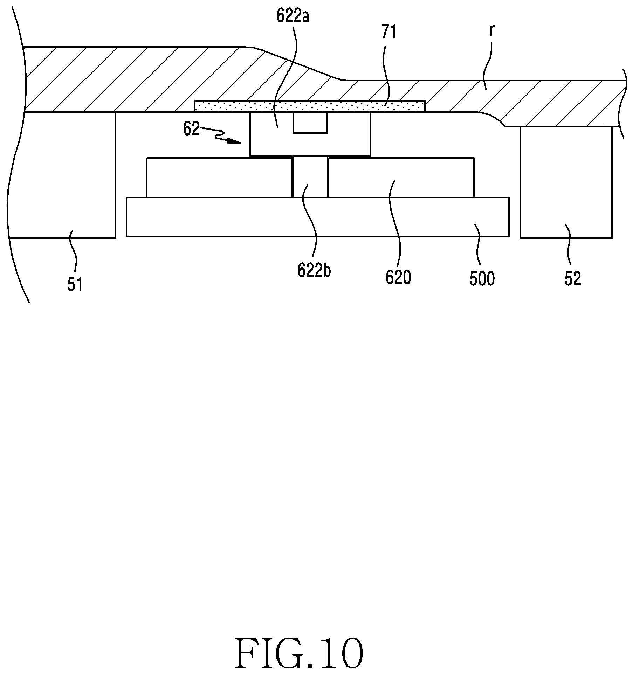

Referring to FIG. 10, according to an embodiment, the conductive structure 62 of FIG. 6 may be electrically connected to an antenna radiator 71 formed on a rear case r. According to an embodiment, a conductive body 622 may electrically connect the antenna radiator 71 and a circuit board. According to an embodiment, one end portion 622a of the conductive body 622 may be connected to the antenna radiator 71, and another end portion 622b may be connected to a connection pad (not shown) of a circuit board (e.g., the circuit board 50 of FIG. 4).

According to an embodiment, a supporting plate 620 of the conductive structure 62 may be grounded to one side of a neck portion 500 of the circuit board, thereby supporting the neck portion 500 while being grounded to the circuit board. According to an embodiment, the conductive body 622 of the conductive structure 62 may electrically connect the antenna radiator 71 and the supporting plate 620, thereby being utilized as part of the antenna radiator 71.

For example, the antenna radiator 71 may include any one of types of a radiator formed in a patterned shape, an antenna disposed in a patch type, and an LDS antenna.

According to an embodiment, the conductive structure 62 may electrically connect the circuit board (e.g., the circuit board 50 of FIG. 4) and the conductive layer 71, thereby being used as a feeding portion of the conductive layer 71. According to an embodiment, when the conductive structure 62 is used as the feeding portion of the conductive layer 71, a copper layer (e.g., a ground portion) of the circuit board (e.g., the circuit board 50 of FIG. 4) may be removed, such that the conductive structure 62 may operate as an antenna radiator.

According to an embodiment, the conductive structure 62 may be used as an antenna tuning point for optimizing antenna performance by partially changing a shape and a material thereof (e.g., changing an antenna resonance point).

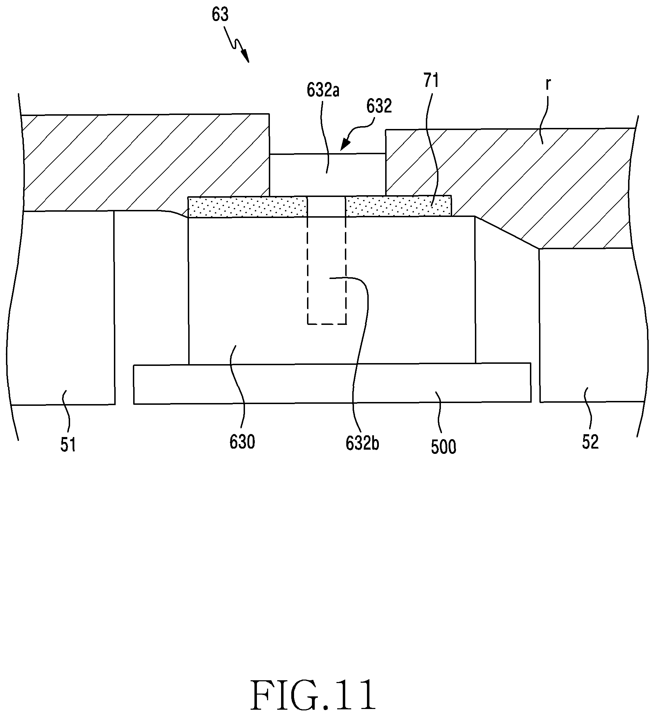

Referring to FIG. 11, according to an embodiment, the conductive structure 63 of FIG. 7 may be electrically connected to an antenna radiator 71 formed on a rear case r. According to an embodiment, a conductive body 632 may penetrate the antenna radiator 71, and then be fastened to a supporting plate 630. According to an embodiment, the antenna radiator 71 may be physically fastened to and electrically connected to the supporting plate 630 by the conductive body 632, thereby being utilized as part of the antenna radiator 71.

According to an embodiment, the supporting plate 630 of the conductive structure 63 may be grounded to one side of a neck portion 500 of a circuit board (e.g., the circuit board 50 of FIG. 4), thereby supporting the circuit board (e.g., the circuit board 50 of FIG. 4) while being grounded to the circuit board (e.g., the circuit board of FIG. 4). According to an embodiment, the conductive body 632 of the conductive structure 63 may electrically connect the antenna radiator 71 and the supporting plate 630, thereby being utilized as part of the antenna radiator 71.

For example, the antenna radiator 71 may include any one of types of a radiator formed in a patterned shape, an antenna disposed in a patch type, and an LDS antenna.

According to an embodiment, the conductive structure 63 may electrically connect the circuit board (e.g., the circuit board 50 of FIG. 4) and the conductive layer 71, thereby being used as a feeding portion of the conductive layer 71. According to an embodiment, when the conductive structure 63 is used as the feeding portion of the conductive layer 71, a copper layer (e.g., a ground portion) of the circuit board (e.g., the circuit board 50 of FIG. 4) may be removed, such that the conductive structure 63 may operate as an antenna radiator.

According to an embodiment, the conductive structure 63 may be used as an antenna tuning point for optimizing antenna performance by partially changing a shape and a material thereof (e.g., changing an antenna resonance point).

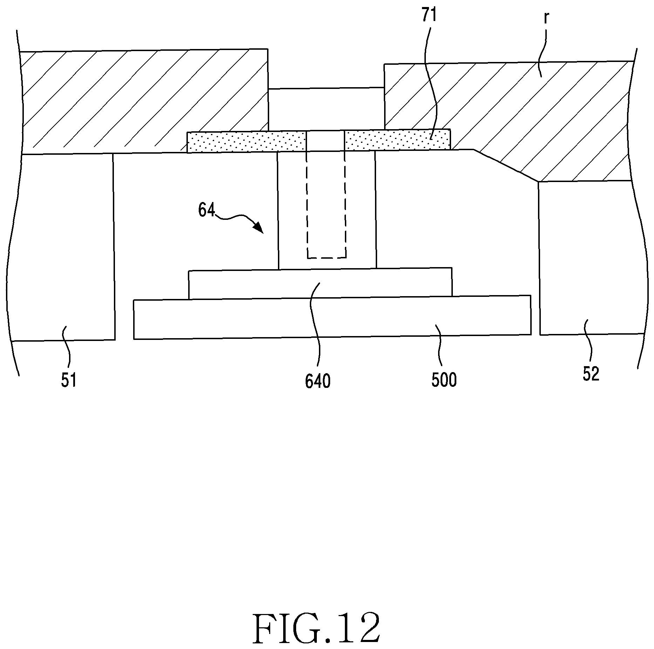

Referring to FIG. 12, according to an embodiment, the conductive structure 64 of FIG. 8 may be electrically connected to an antenna radiator 71 formed on a rear case r. According to an embodiment, a conductive body 642 may penetrate the antenna radiator 71, and then be fastened to a supporting plate 640. According to an embodiment, the antenna radiator 71 may be physically fastened to and electrically connected to the supporting plate 640 by the conductive body 642 and a fastening portion 6401, thereby being utilized as part of the antenna radiator 71.

According to an embodiment, the supporting plate 640 of the conductive structure 64 may be grounded to one side of a neck portion 500, thereby supporting the neck portion 500 while being grounded to the circuit board (e.g., the circuit board of FIG. 4). According to an embodiment, the conductive body 642 and fastening portion 6401 of the conductive structure 64 may electrically connect the antenna radiator 71 and the supporting plate 640, thereby being utilized as part of the antenna radiator 71.

For example, the antenna radiator 71 may include any one of types of a radiator formed in a patterned shape, an antenna disposed in a patch type, and an LDS antenna.

According to an embodiment, the conductive structure 64 may electrically connect the circuit board (e.g., the circuit board 50 of FIG. 4) and the conductive layer 71, thereby being used as a feeding portion of the conductive layer 71. According to an embodiment, when the conductive structure 64 is used as the feeding portion of the conductive layer 71, a copper layer (e.g., a ground portion) of the circuit board (e.g., the circuit board 50 of FIG. 4) may be removed, such that the conductive structure 64 may operate as an antenna radiator.

According to an embodiment, the conductive structure 64 may be used as an antenna tuning point for optimizing antenna performance by partially changing a shape and a material thereof (e.g., changing an antenna resonance point).

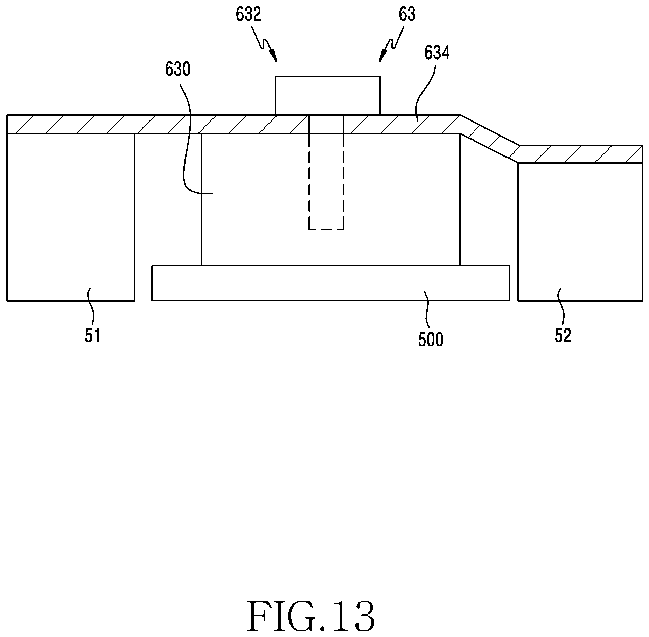

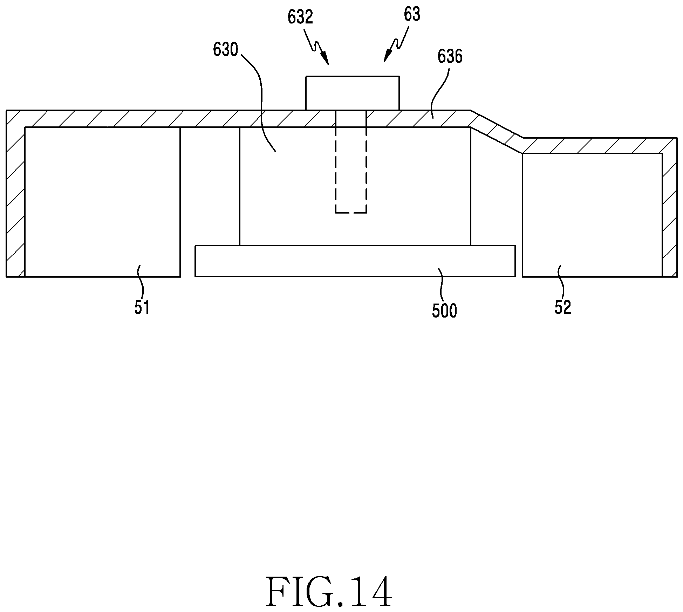

FIG. 13 and FIG. 14 are cross-sectional views each illustrating a conductive structure having a shielding function according to an embodiment.

Referring to FIG. 13, according to an embodiment, the conductive structure 63 of FIG. 7 may be fastened to a shielding plate 634 to perform a shielding function for first and second electronic components 51 and 52.

According to an embodiment, the shielding plate 634 may be fastened to a supporting plate 630 by a conductive body 632. According to an embodiment, the shielding plate 634 may have a shape which surrounds, at least in part, the supporting plate 630 and the first and second electronic components 51 and 52. For example, a portion surrounded at least in part may be upper sides of the first and second electronic components 51 and 52 and the shielding plate 634. According to an embodiment, an inner space between the supporting plate 630 and the first and second electronic components 51 and 52 may be surrounded by the shielding plate 634. Noise produced from a circuit board may be absorbed by the shielding plate 634, such that the shielding plate 634 may contribute to improvement of antenna performance. For example, the shielding plate 634 may be formed of the same material as or a different material from the supporting plate 630, and may have the same thickness as or a different thickness from the supporting plate 630.

Referring to FIG. 14, according to an embodiment, the conductive structure 63 of FIG. 7 may be fastened to a shielding plate 636 to perform a shielding function for first and second electronic components 51 and 52.

According to an embodiment, the shielding plate 636 may perform a shielding function to prevent noise produced from one electronic component from affecting another component, for example, the first component 51 or the second component 52, or to prevent another component from affecting the first component 51 or second component 52 disposed in the shielding plate 636. For example, when the first component 51 is a camera module, transmission power of an antenna radiator applied to the camera module may be blocked by the shielding plate 636.

According to an embodiment, the shielding plate 636 may be fastened to a supporting plate 630 by a conductive body 632. According to an embodiment, the shielding plate 636 may have a shape which surrounds, at least in part, the first and second electronic components 51 and 52. For example, a portion surrounded at least in part by the shielding plate 636 may be upper and lateral sides of the first and second electronic components 51 and 52, and the supporting plate 630. According to an embodiment, an inner space between the supporting plate 630 and the first and second electronic components 51 and 52 may be surrounded by the shielding plate 636. According to an embodiment, noise produced from the circuit board may be absorbed by the shielding plate 636, such that the shielding plate 636 may contribute to improvement of antenna performance.

According to an embodiment, the conductive structure 63 may be disposed between a circuit board (e.g., the circuit board 50 of FIG. 4) and at least part of a housing, thereby electrically connecting the circuit board and at least part of the housing. According to an embodiment, for example, when part of the housing is formed of a metal material, the conductive structure 63 may be used to enhance grounding performance between the circuit board and the housing.

According to an embodiment, the conductive structure 63 may be disposed such that the circuit board (e.g., the circuit board 50 of FIG. 4) and at least part of the housing are electrically connected. According to an embodiment, for example, when part of the housing is formed of a metal material and serves as an antenna radiator, the conductive structure 63 may be used to enhance a radiation function of the antenna radiator.

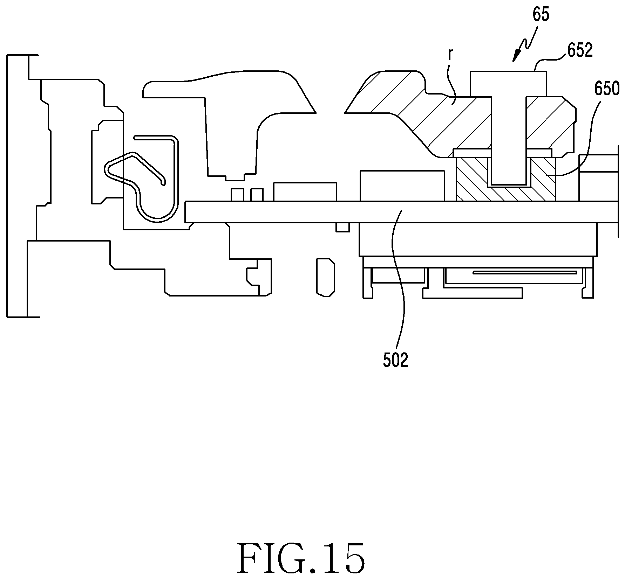

FIG. 15 is a cross-sectional view illustrating a conductive structure disposed to a non-neck portion of various circuit boards according to an embodiment.

Referring to FIG. 15, according to an embodiment, a conductive structure 65 may include a supporting plate 650 disposed on or grounded to one side of a non-neck portion 502 of a circuit board, and a conductive body 652 which penetrates a rear case r and is fastened to the supporting plate 650. According to an embodiment, the conductive structure 65 may be equally applied not only to a neck portion 500 of the circuit board but also to the non-neck portion 502 which is different from the neck portion 500.

According to an embodiment, the conductive structures 61 to 64 of FIG. 5 to FIG. 8 may be equally applied to the non-neck portion 502 of the circuit board.

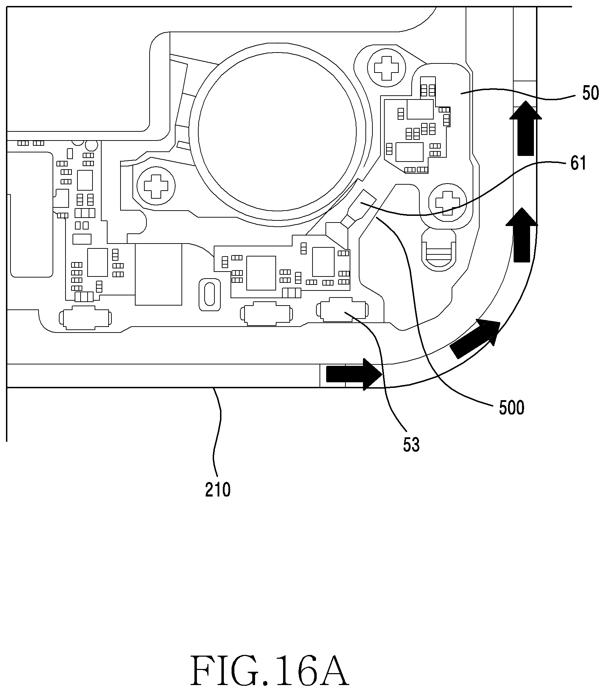

FIG. 16A is a plan view illustrating a state in which a conductive structure is disposed adjacent to an antenna feeding portion according to an embodiment.

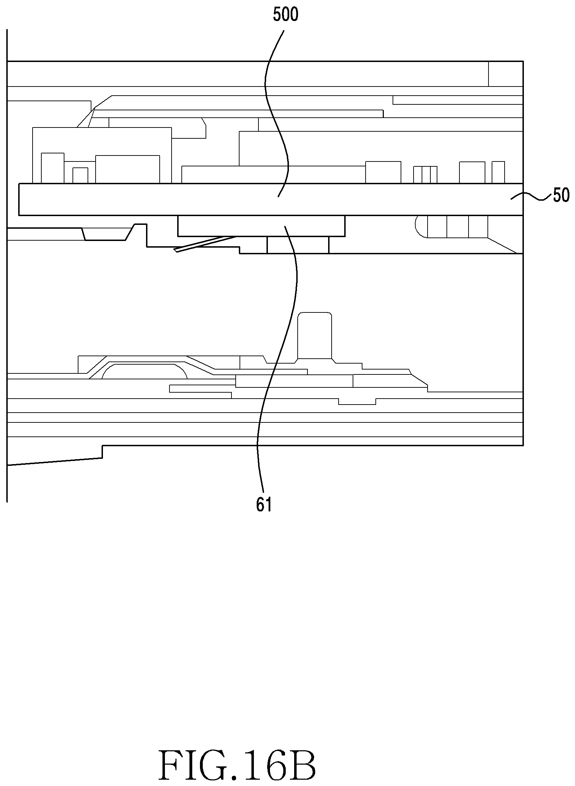

FIG. 16B is a lateral view illustrating a state in which a conductive structure is disposed to a neck portion according to an embodiment.

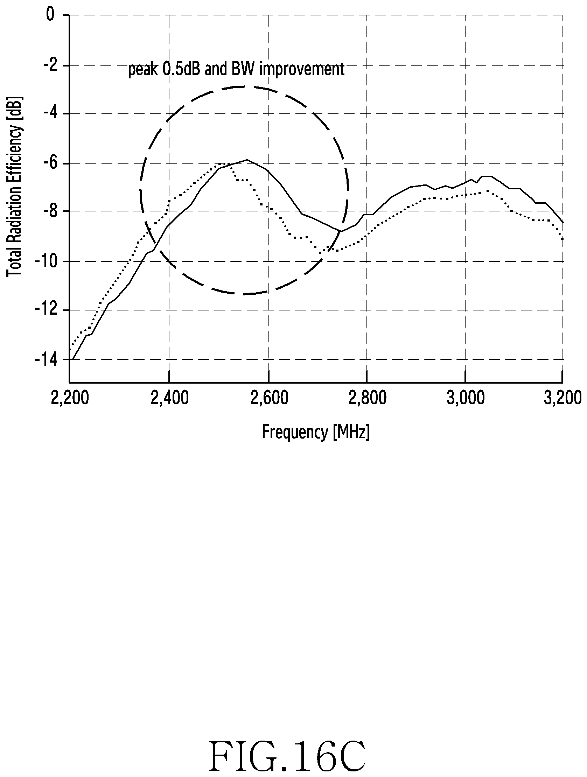

FIG. 16C is a comparative graph illustrating radiation efficiencies of a conductive structure according to a comparative example and a conductive structure according to an embodiment, respectively.

Referring to FIG. 16A and FIG. 16B, according to an embodiment, when a conductive structure 61 is disposed on a neck portion 500 of a circuit board 50 at a position adjacent to an antenna feeding portion 53 (a radiation current supply point), the conductive structure 61 may be grounded to the circuit board 50, thereby maximizing radiation efficiency of an antenna radiator.

Referring to FIG. 16C, radiation efficiencies of a conductive structure according to a comparative example (dotted line) and a conductive structure according to an embodiment (e.g., the conductive structure 61 of FIG. 5) (solid line) are measured. As a result, it is shown that radiation characteristics of the conductive structure according to the embodiment are improved by approximately 0.5 decibels (dB) compared to those of the conductive structure according to the comparative example, and that a bandwidth (BW) is also improved. In the graph of FIG. 16C, a horizontal axis represents frequency, and a vertical axis represents overall radiation efficiency.

The conductive structure according to the comparative example refers to a structure in which a supporting plate is disposed on one side of a circuit board and a conductive body (e.g., a clip) is disposed on the other side of the circuit board, whereas the conductive structure according to an embodiment may be the conductive structure 61 of FIG. 5.

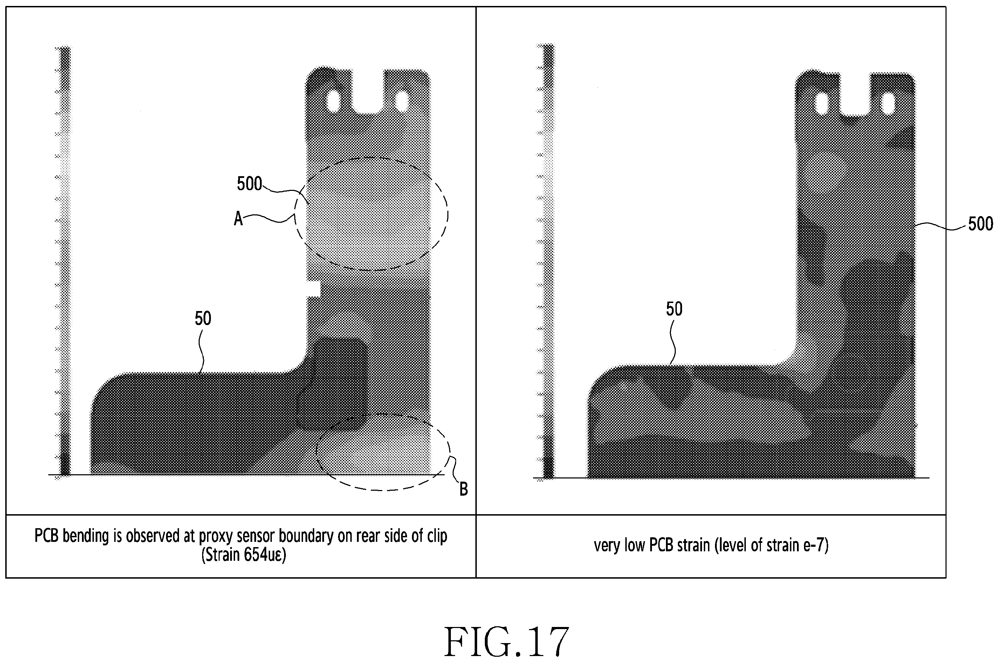

FIG. 17 is a comparative exemplary view illustrating stresses occurring at a conductive structure according to a comparative example and at a neck portion of conductive structure according to an embodiment.

Referring to FIG. 17, stresses applied to a neck portion of a circuit board by a conductive structure according to a comparative example and a conductive structure according to an embodiment (e.g., the conductive structure 61 of FIG. 5) are measured. As a result, in case of the conductive structure according to the comparative example, bending (strain 654 µε) is observed approximately at a sensor boundary near a rear side of a conductive body (e.g., a clip) in the neck portion of the circuit board, whereas in case of the conductive structure according to the embodiment, substantially no stress caused by the conductive body (e.g., a clip) occurs in the neck portion of the circuit board (at a level of strain e-7).

The conductive structure according to the comparative example refers to a structure in which a supporting plate 610 is disposed on one side of the neck portion of the circuit board, and a conductive body (e.g., a clip) is disposed on the same side of the neck portion of the circuit board at a position spaced apart from the supporting plate 610, whereas the conductive structure according to an embodiment may be the conductive structure 61 of FIG. 5.

In the shaded representation of the circuit board 50 of FIG. 17, brighter regions A and B may indicate portions of a neck portion 500 of a circuit board 50 in which greater stress occurs, whereas darker regions may indicate portions in which less stress occurs. A vertical axis of FIG. 17 represents effective strain.

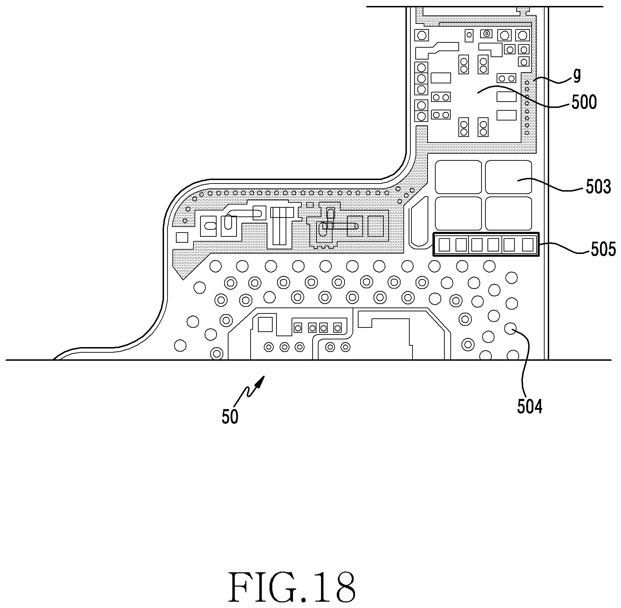

Referring to FIG. 18, according to an embodiment, a region in which a supporting plate is disposed may be set to be sufficiently wide to ensure rigidity of a circuit board 50. According to an embodiment, a ground layer g of the circuit board 50 corresponding to an entire region of the supporting plate may be removed (fill cut), such that the supporting plate may be used as an antenna radiator. For example, when the ground layer g (e.g., a ground line) formed on the circuit board 50 is removed, the supporting plate according to an embodiment (e.g., the supporting plate 610 of FIG. 5) may be utilized as the antenna radiator rather than serving a grounding function.

According to an embodiment, when the ground layer g formed on the circuit board 50 is not removed, the supporting plate according to an embodiment (e.g., the supporting plate 610 of FIG. 5) may be bonded to the ground layer g by soldering, and thus may be utilized as a grounding member rather than serving an antenna radiator function.

According to an embodiment, for antenna tuning, an inductor and/or a capacitor may be disposed adjacent to the supporting plate (e.g., the supporting plate 610 of FIG. 5). According to an embodiment, in order to secure a radiation volume, the ground layer g of the circuit board 50 may be removed not only from a topmost layer of the circuit board 50 but also from approximately four to six layers thereof. Lines of components disposed on a neck portion 500 of the circuit board 50, which is formed to be narrow and elongated using the remaining layers, may be wired using lower layers beneath the removed ground layers. In the corresponding region, since many lines are not typically required for components such as sensors and antenna switches, wiring may be implemented using only a limited number of layers.

According to an embodiment, when the supporting plate (e.g., the supporting plate 610 of FIG. 5) is utilized as an antenna radiator, the supporting plate (e.g., the supporting plate 610 of FIG. 5) electrically connected to the antenna radiator functions as part of the antenna radiator. Therefore, in order to further enhance antenna performance, the supporting plate may be used as a turning portion by modifying a shape and material thereof.

According to an embodiment, when a rigidity reinforcement level of the neck portion 500 of the circuit board is reduced due to fill-cut, a pad may be formed on an inner layer in the same manner as a pad 503 disposed as an SMD formed on an upper side of the circuit board, and then a via 504 may be applied to some of layers. A reference numeral 505 denotes a matching portion for tuning of an antenna disposed on the circuit board.

According to an embodiment, an electronic device (e.g., the electronic device 101 of FIG. 1) may include: a housing (e.g., the first housing 210 of FIG. 1) including a front plate, a rear plate, and a lateral member surrounding at least part of an inner space between the front plate and the rear plate; a first electronic component (e.g., the first electronic component 51 of FIG. 4) disposed in the housing; a second electronic component (e.g., the second electronic component 52 of FIG. 4) spaced apart from the first electronic component and disposed in the housing; a circuit board (e.g., the circuit board 50 of FIG. 4) disposed between the front plate and the rear plate and including at least one neck portion (e.g., the neck portion 500 of FIG. 4) disposed between the first electronic component and the second electronic component; a rear case (e.g., the rear case r of FIG. 9) disposed between the circuit board and the rear plate and having at least one conductive layer (e.g., the conductive layer 71 of FIG. 9) formed on one side facing one side of the circuit board; a metal supporting plate (e.g., the supporting plate 610 of FIG. 5) supporting the at least one neck portion and disposed on the one side of the circuit board; and a conductive body (e.g., the conductive body 612 of FIG. 5) electrically connecting the supporting plate and the conductive layer of the rear case and disposed on the supporting plate.

According to an embodiment, the supporting plate (e.g., the supporting plate 610 of FIG. 5) may be grounded to the circuit board (e.g., the circuit board 50 of FIG. 4).

According to an embodiment, the conductive layer (e.g., the conductive layer 71 of FIG. 9) may include at least one antenna radiator.

According to an embodiment, the first electronic component (e.g., the first electronic component 51 of FIG. 4) may include any one of a camera module and a motor. The second electronic component (e.g., the second electronic component 52 of FIG. 4) may include any one of a speaker, a display DDI, an AP, an LNA, and a filter.

According to an embodiment, in a top view above the supporting plate (e.g., the supporting plate 610 of FIG. 5), the conductive layer (e.g., the conductive layer 71 of FIG. 9) may be disposed to overlap at least in part with the supporting plate and the neck portion (e.g., the neck portion 500 of FIG. 4).

According to an embodiment, the conductive body (e.g., the conductive 622 of FIG. 6), as a metal fastener, may be fastened to the supporting plate by penetrating the conductive layer.

According to an embodiment, the supporting plate (e.g., the supporting plate 610 of FIG. 5) and the conductive layer (e.g., the conductive layer 71 of FIG. 9) may be electrically connected by the conductive body, such that the supporting plate may operate as part of an antenna radiator.

According to an embodiment, the conductive body (e.g., the conductive 632 of FIG. 11), as a metal fastener, may be fastened to the supporting plate (e.g., the supporting plate 630 of FIG. 11) by penetrating the rear case (e.g., the rear case r of FIG. 11) and the conductive layer (e.g., the conductive layer 71 of FIG. 11).

According to an embodiment, the conductive body (e.g., the conductive body 612 of FIG. 9), as a metal clip, may have one end portion which is in contact with the supporting plate (e.g., the supporting plate 610 of FIG. 9) and another end portion which is in elastic contact with the conductive layer (e.g., the conductive layer 71 of FIG. 9).

According to an embodiment, the conductive body (e.g., the conductive body 642 of FIG. 8) may include: a fastening portion (e.g., the fastening portion 6401 of FIG. 8) formed upright on one side of the supporting plate; and a metal fastener (e.g., the metal fasteners 642a and 642b of FIG. 8) penetrating the conductive pattern and fastened to the fastening portion.

According to an embodiment, the electronic device may further include a shielding plate (e.g., the shielding plate 634 of FIG. 13) disposed to surround a space between the first electronic component (e.g., the first electronic component 51 of FIG. 13) and the second electronic component (e.g., the second electronic component 52 of FIG. 13).

According to an embodiment, the shielding plate (e.g., the shielding plate 634 of FIG. 13) may be fastened to the supporting plate (e.g., the supporting plate 630 of FIG. 13) by using a metal fastener (e.g., the conductive body 632 of FIG. 13).

According to an embodiment, in a top view above the shieling plate (e.g., the shielding plate 634 of FIG. 13), the metal fastener (e.g., the conductive body 632 of FIG. 13), the shielding plate (e.g., the shielding plate 634 of FIG. 13), and the supporting plate (e.g., the supporting plate 630 of FIG. 13) may be disposed to overlap each other vertically.

According to an embodiment, an electronic device (e.g., the electronic device 101 of FIG. 1) may include: a circuit board (e.g., the circuit board 50 of FIG. 4) having a first electronic component (e.g., the first electronic component 51 of FIG. 4) disposed on one side and a second electronic component (e.g., the second electronic component 52 of FIG. 4) spaced apart from the first electronic component, and including at least one neck portion (e.g., the neck portion 500 of FIG. 4) disposed between the first electronic component and the second electronic component; a rear case (e.g., the rear case r of FIG. 9) disposed to face the circuit board and having at least one conductive layer (e.g., the conductive layer 71 of FIG. 9) formed on one side facing one side of the circuit board (e.g., the circuit board 51 of FIG. 4); a metal supporting plate (e.g., the supporting plate 610 of FIG. 9) supporting the at least one neck portion and disposed on the one side of the circuit board; and a conductive body (e.g., the conductive body 612 of FIG. 9) electrically connecting the supporting plate and the conductive pattern and disposed on the supporting plate.

According to an embodiment, the supporting plate (e.g., the supporting plate 610 of FIG. 9) may be grounded to the circuit board (e.g., the circuit board 50 of FIG. 4).

According to an embodiment, the conductive layer (e.g., the conductive layer 71 of FIG. 9) may include at least one antenna radiator.

According to an embodiment, the first electronic component (e.g., the first electronic component 51 of FIG. 9) may include a camera module, and the second electronic component (e.g., the second electronic component 52 of FIG. 9) may include a speaker.

According to an embodiment, in a top view above the supporting plate (e.g., the supporting plate 610 of FIG. 9), the conductive layer (e.g., the conductive layer 71 of FIG. 9) may be disposed to overlap at least in part with the supporting plate and the neck portion (e.g., the neck portion 500 of FIG. 9).

According to an embodiment, the supporting plate (e.g., the supporting plate 610 of FIG. 9) and the conductive layer (e.g., the conductive layer 71 of FIG. 9) may be electrically connected by the conductive body (e.g., the conductive body 612 of FIG. 9), such that the supporting plate may operate as part of an antenna radiator.

According to an embodiment, the electronic device may further include a shielding plate (e.g., the shielding plate 634 of FIG. 13) disposed to surround at least part of the first electronic component (e.g., the first electronic component 51 of FIG. 13) and the second electronic component (e.g., the second electronic component 52 of FIG. 13). The shielding plate may be fastened to the supporting plate (e.g., the supporting plate 630 of FIG. 13) by using a metal fastener (e.g., the conductive body 632 of FIG. 13).

## Claims

1. An electronic device comprising:
a housing including a front plate, a rear plate, and a lateral member surrounding at least part of an inner space between the front plate and the rear plate;
a first electronic component disposed in the housing;
a second electronic component spaced apart from the first electronic component and disposed in the housing;
a circuit board disposed between the front plate and the rear plate and including at least one neck portion disposed between the first electronic component and the second electronic component;
a rear case disposed between the circuit board and the rear plate and having at least one conductive layer formed on one side facing one side of the circuit board;
a metal supporting plate supporting the at least one neck portion and disposed on the one side of the circuit board; and
a conductive body electrically connecting the supporting plate and the conductive layer of the rear case and disposed on the supporting plate.

2. The electronic device of claim 1, wherein the supporting plate is operable as a grounding member when grounded to the circuit board, or operable as an antenna radiator when electrically connected to the conductive layer.

3. The electronic device of claim 1, wherein the conductive layer includes at least one antenna radiator.

4. The electronic device of claim 1,
wherein the supporting plate is a component which prevents interference between the first and second electronic components, and
wherein the first electronic component includes any one of a camera module and a motor, and the second electronic component includes any one of a speaker, a microphone, a display driver IC (DDI), an application processor (AP), a low noise amplifier (LNA), and a filter.

5. The electronic device of claim 1, wherein, in a top view of the supporting plate, the conductive layer is disposed to overlap at least in part with the supporting plate and the neck portion.

6. The electronic device of claim 3, wherein the conductive body, as a metal fastener, is fastened to the supporting plate by penetrating the conductive layer.

7. The electronic device of claim 6, wherein the supporting plate and the conductive layer are electrically connected by the conductive body, such that the supporting plate operates as part of an antenna radiator.

8. The electronic device of claim 1, wherein the conductive body, as a metal fastener, is fastened to the supporting plate by penetrating the rear case and the conductive pattern.

9. The electronic device of claim 1, wherein the conductive body, as a metal clip, has one end portion which is in contact with the supporting plate and another end portion which is in elastic contact with the conductive layer.

10. The electronic device of claim 1, wherein the conductive body comprises:
a fastening portion formed upright on one side of the supporting plate; and
a metal fastener penetrating the conductive pattern and fastened to the fastening portion.

11. The electronic device of claim 1, further comprising a shielding plate disposed to surround at least part of the first electronic component and the second electronic component.

12. The electronic device of claim 11, wherein the shielding plate is fastened to the supporting plate by using a metal fastener.

13. The electronic device of claim 12, wherein, in a top view above the shieling plate, the metal fastener, the shielding plate, and the supporting plate are disposed to overlap each other vertically.

14. The electronic device of claim 12, wherein the shielding plate is formed to surround at least part of an inner space formed by the first electronic component, the second electronic component, and the supporting plate.

15. The electronic device of claim 14, wherein the shielding plate is formed of a material which absorbs noise produced from the circuit board.
